# EUROPÄISCHE PATENTANMELDUNG

(11) **EP 2 357 482 A1**
(43) Veröffentlichungstag der Anmeldung: **17.08.2011**
(21) Anmeldenummer: 11003137.4
(22) Anmeldetag: 23.01.2008
(51) Int. Cl.: G01R 15/08, G01R 31/02, H02H 1/00

(54) **Verfahren und Vorrichtung zur Auswertung schneller Stromänderungen**

(30) Priorität: 22.03.2007 DE 102007013712
(62) Teilanmeldung aus: 08707210.4
(71) Anmelder: Ellenberger & Poensgen GmbH, D-90518 Altdorf (DE)
(72) Erfinder: Naumann, Michael, 90537 Feucht (DE); Miklis, Markus, 90592 Pfeifferhütte (DE)
(74) Vertreter: FDST Patentanwälte

(57) **Zusammenfassung**

Zur Erfassung und Auswertung von Stromänderungen in Folge von Lichtbögen wird ein nach der Zeit (t) differenziertes Sensorsignal (di/dt) mit einer sensorabhängigen Frequenzbandbreite (f_{go1} - f_{gu}) erzeugt, deren obere Grenzfrequenz (f_{go1}) 40MHz und deren untere Grenzfrequenz (f_{gu}) 100kHz beträgt, wobei aus dem Sensorsignal (S_{A}) ein Auswertesignal (S'_{A}) mit einer oberen Grenzfrequenz (f_{go2}) kleiner oder gleich 10MHz erzeugt wird, wobei das Auswertesignal (S'_{A}) mit einem Schwellwert verglichen und ein normiertes Signal (S_{D}, S'_{D}) erzeugt wird, und wobei die Pulsdauer des Signals (S_{D}, S'_{D}) auf einen vorgegebenen Zeitwert (Δt₂) verlängert wird.

## Beschreibung

Die Erfindung bezieht sich auf ein Verfahren und eine Vorrichtung zur Auswertung sensorisch erfasster schneller Stromänderungen in Folge von Lichtbögen.

Zur Messung eines sich zeitlich ändernden elektrischen Stromes, insbesondere mit steilflankigen, schnellen Stromänderungen, ist es aus der WO 2005/098458 A1 bekannt, einen Sensor mit einem ferromagnetischen Koppelelement und mit einer diesen umgebenden Sekundär- oder Sensorwicklung sowie mit einer Primär bzw. Erregerwicklung einzusetzen, die denjenigen Strom führt, dessen schnellen Stromänderungen erfasst werden sollen. An den Anschlussenden der Sensorwicklung ist ein Strom- oder Spannungssignal abgreifbar, dass aus der Steigungsänderung (d²I_{P}/dt²) infolge hochfrequenter Signalanteile im Stromsignal und der Dämpfung (Verstärkung) infolge der Kopplung der Sensorwicklung mit der Erregerwicklung über das ferromagnetische Koppelelement resultiert. Dieses Signal wird mit einem Analog/Digital-Wandler abgetastet. Mit dem bekannten Sensor, der keine proportionale Strommessung durchführt, sondern Änderungen der Stromstärke in einem bestimmten Frequenzbereich erfasst, können Ereignisse in Folge von Lichtbögen mit geringem Aufwand erfasst werden.

Der Erfindung liegt die Aufgabe zugrunde, einen besonders geeignetes Verfahren und eine Vorrichtung zur Auswertung von sensorisch erfassten schnellen Stromänderungen in Folge von Lichtbögen anzugeben.

Bezüglich des Verfahrens wird die genannte Aufgabe erfindungsgemäß gelöst durch die Merkmale des Anspruchs 1. Vorteilhafte Weiterbildungen sind Gegenstand der hierauf rückbezogenen Unteransprüche.

Zur Erfassung und Auswertung von Stromänderungen in Folge von Lichtbögen sieht das erfindungsgemäße Verfahren vor, aus einem zeitdifferenzierten und bandpassgefilterten Sensorsignal ein verarbeitbares Auswertesignal zu erzeugen. Die sensorabhängige Bandbreite des Sensorsignals liegt zwischen der oberen Grenzfrequenz von 40 MHz und der unteren Grenzfrequenz von 100kHz. Dieses (nach der Zeit) differenzierte Auswerte- oder Sensorsignal wird anschließend frequenzgefiltert. Ein entsprechendes Auswertesignal mit einer oberen Grenzfrequenz vorzugsweise kleiner 10 MHz wird anhand eines spannungsbezogenen Schwellwert-Vergleiches digitalisiert.

Bei dem dabei erzeugten, nachfolgend auch als Pulssignal bezeichneten Signal mit normierter Signalhöhe (Amplitude) wird die Pulsdauer auf einen vorgegebenen Zeitwert, insbesondere auf 100µs, verlängert. Vorzugsweise wird dabei die Pulsdauer eines einzelnen Signalpulses nur dann verlängert und dieser somit lediglich dann ausgewertet und/oder weiterverarbeitet, wenn innerhalb des Zeitfensters mehrere aufeinander folgende Signalpulse (Impulse) gezählt werden. Der Zeitwert der Pulsverlängerung ist dabei zweckmäßigerweise auf die Verarbeitungszeit oder-geschwindigkeit eines geeigneterweise zur Signalauswertung eingesetzten Mikroprozessors oder -controllers eingestellt.

Gemäß einer bevorzugten Variante des Verfahrens wird nicht nur die Signalhöhe normiert, sondern es wird auch die Dauer oder Pulsdauer des noch unverlängerten Signals auf einen vorgegebenen Zeitwert normiert. Anschließend werden zweckmäßigerweise aufeinander folgende normierte Pulssignale innerhalb eines vorgegebenen Zeitfensters, insbesondere mit einem Zeitintervall von 10µs, gezählt.

Eine zur Durchführung des Verfahrens besonders geeignete Vorrichtung weist erfindungsgemäß zusätzlich zu einem zur Erfassung schneller Stromänderungen geeigneten und vorzugsweise möglichst raumsparenden Stromsensor eine mit diesem verbundene Auswerteelektronik zur Signalverarbeitung auf. Diese ist dazu vorgesehen und eingerichtet, das an der Sensorwicklung des Sensors abgreifbare frequenzabhängige Sensorsignal in digitale Signale umzuformen, diese zu zählen und anschließend die Pulsdauer des Signals bzw. Signalpulses auf einen vorgegebenen Zeitwert zu verlängern.

Ein in vorteilhafter Ausgestaltung einem Analog-Digital-Wander der Auswerteelektronik nachgeschaltetes Normierglied dient zur zeitlichen Signalnormierung. Die Auswerteelektronik weist des Weiteren zweckmäßigerweise einen Zähler zur Erfassung der Anzahl der Pulssignale bzw. Signalpulse auf. Ferner weist die Auswerteelektronik geeigneterweise eine Sample- und Hold-Schaltung zur Verlängerung der Pulsdauer des Pulssignals auf.

Die mit der Erfindung erzielten Vorteile bestehen insbesondere darin, dass bei gleichzeitig kleinem Bauvolumen sowie geringem Stromverbrauch und geringer Rechenleistung des Erfassungs- und Auswertesystems eine direkte Lichtbogenerkennung bei hoher Störfestigkeit ermöglicht ist.

Nachfolgend werden Ausführungsbeispiele der Erfindung anhand einer Zeichnung näher erläutert. Darin zeigen:
- Fig. 1: schematisch das Übertragungsverhalten einer Vorrichtung zur Erfassung und Auswertung von Stromänderungen mit einem Sensorbaustein sowie mit einer Auswerteelektronik zur Verarbeitung der in Diagrammen veranschaulichten Signale, und
- Fig. 2: den Aufbau eines geeigneten Stromsensors zur Erfassung schneller Stromänderungen.

Einander entsprechende Teile sind in beiden Figuren mit den gleichen Bezugszeichen versehen.

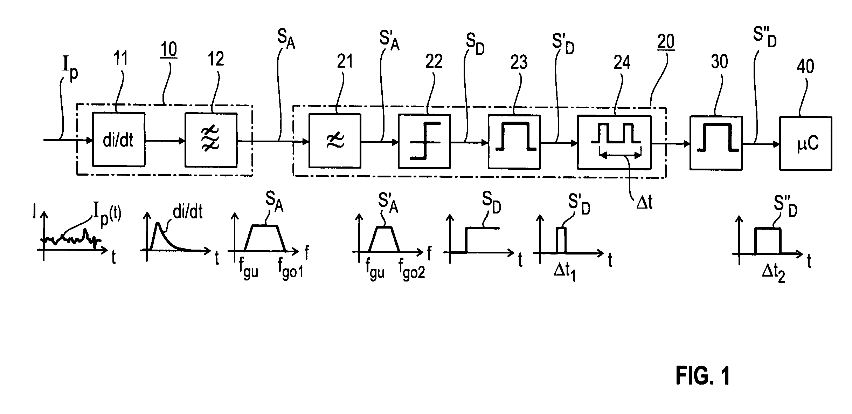

Fig. 1 zeigt in einem Blockdiagramm die wesentlichen Bausteine der Vorrichtung zur Erfassung und Auswertung von Stromänderungen infolge von Lichtbögen mit einem Sensorbaustein 10 und einer Auswerteelektronik 20 zur Signalverarbeitung sowie mit einem Funktionsbaustein 30 zur Signalweiterverarbeitung und mit einem Mikrocontroller 40 zur Signalanalyse. Der nachfolgend auch als Stromsensor bezeichnete Sensorbaustein 10 umfasst die Funktionselemente eines zeitlichen Stromdifferenzierers (Differenzierfunktion di/dt) 11 und eines Bandpasses (Bandpassfunktion) 12.

Die Auswerteelektronik 20 umfasst eingangsseitig einen Tiefpass 21 und diesem nachgeordnet einen Analog-Digital-Wandler (AD-Wandler) in Form vorzugsweise eines Komparators oder 1-Bit-Wandlers 22, dem ein Normierglied 23 nachgeordnet ist. Dem Normierglied 23 wiederum ist ein Funktionsbaustein 24 zur Zeitanalyse, beispielsweise ein Zähler, nachgeordnet. Der Funktionsbaustein 30 ist zweckmäßigerweise in einen Mikroprozessor, beispielsweise in den Mikrocontroller 40 integriert.

Die unterhalb der Blockdarstellung gezeigten Diagramme veranschaulichen die jeweiligen Signale am Eingang bzw. Ausgang sowie die Übertragungsfunktion der entsprechenden Funktionsblöcke oder -bausteine. So zeigt das in der Fig. 1 linke Diagramm das zu erfassende und auszuwertende Stromsignal I_{P}, dessen zeitliche Änderung (di/dt) 11 mittels des Sensors 10 detektiert wird. Die zugeordnete Bandpassfunktion 12 weist eine obere Grenzfrequenz f_{go1}, vorzugsweise mit f_{go1} = 40 MHZ, und eine untere Grenzfrequenz f_{gu}, vorzugsweise mit f_{gu} = 100 kHz, auf.

Das am Ausgang des Sensors 10 abgreifbare, zeitdifferenzierte und bandpassgefilterte Sensorsignal S_{A} wird mittels der Auswerteelektronik 20 in dem dort eingangsseitig vorgesehenen Tiefpass 21 frequenzgefiltert. Der Tiefpass 21 weist dabei eine obere Grenzfrequenz f_{go2} auf, mit f_{go2} < 10 MHZ, vorzugsweise f_{go2} < 5 MHZ. Das tiefpassgefilterte Sensor- oder Auswertesignal S'_{A} wird mittels des nachgeordneten AD-Wandler 22 digitalisiert. Das Digitalsignal S_{D} ist hinsichtlich dessen Signalhöhe U mit typisch U = 5V normiert. Dieser Schwellwert ist im mV-Bereich einstellbar, um eine sichere Detektion der überzeichneten Lichtbogensignale zu gewährleisten.

In dem nachgeordneten Normierglied 23 wird die Pulsdauer oder Pulslänge des Pulssignals zeitlich normiert auf einen Zeitwert von Δt₂ « Δt. In dem nachfolgenden Zähler 24 werden die Signalpulse des Normierglieds 23 gezählt. Werden dabei innerhalb eines eingestellten Zeitfensters von beispielsweise Δt = 10 µs zwei zeitlich normierte Impulse oder Pulssignale S'_{D} erkannt, so wird ein einzelnes Pulssignal bzw. ein einzelner Signalpuls (Einzelimpuls) an den Funktionsbaustein 30 zur Signalverlängerung weitergegeben. Andernfalls werden erfasste oder erkannte Pulssignale S'_{D}, d.h. entsprechende Einzelimpulse ignoriert.

Der Funktionsbaustein 30 umfasst im Wesentlichen eine so genannte Sample- and Hold-Schaltung, die den weitergegeben Einzelimpuls des Pulssignals S'_{D} auf eine Pulsdauer von Δt₂ » Δt₁ verlängert. Hierdurch verbleibt einem dem Funktionsbaustein 30 nachgeordneten Mikrocontroller 40 genügend Zeit, das verlängerte Pulssignal S"_{D} zu erkennen. Der Mikrocontroller 40 erhält demnach lediglich die Information, dass innerhalb der vergangenen Pulsdauer von Δt₂ mehrere Einzelimpulse bzw. ein Signal S_{A} mit einer Frequenz zwischen 100 kHz und 4 MHz aufgetreten sind. Liegt demgegenüber für eine vergleichsweise lange Zeitdauer eine konstante Frequenz größer 100 kHz an, so liefert der Funktionsbaustein 30 an den Mikroprozessor 40 lediglich einen High-Pegel. Ein derartiger, dauerhafter High-Pegel ist jedoch erkanntermaßen nicht auf einen Lichtbogen zurückzuführen.

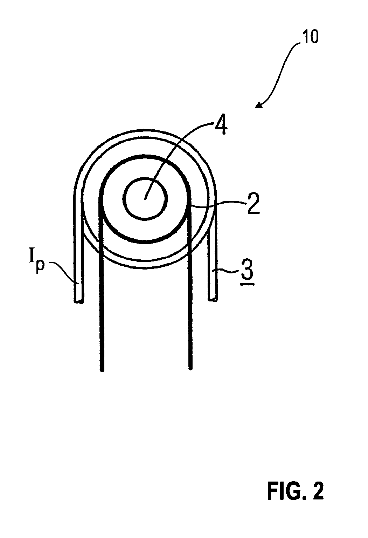

Gemäß Fig. 2 ist der Stromsensor 10 aus einer Sensorwicklung oder -spule 2, die zusammen mit einer Erregerwicklung 3 um ein gemeinsames Koppelelement 4 gewickelt ist, aufgebaut. Dabei liegt die Erregerwicklung 3 über der Sensorwicklung 2, die wiederum das Koppelelement 4 umgibt. Das zylinder- oder stabförmig ausgebildete und ferromagnetische Koppelelement 4 durchdringt beide Wicklungen 2, 3 einstückig. Dabei sind die aus mehreren Sensorwindungen bestehende Sensorwicklung 2 und die Erregerwicklung 3, die ebenfalls aus mehreren Windungen bestehen kann, voneinander galvanisch getrennt auf das Koppelelement 4 montiert.

Das Koppelelement 4 und die beiden Wicklungen 2, 3 sowie die Auswerteelektronik 20, der Funktionsbaustein 30 und/oder der Mikrocontroller 40 sind vorzugsweise in einem Gehäuse angeordnet, das auch dasjenige eines Schutzschalters oder Schutzschaltrelais sein kann.

### Bezugszeichenliste

- 2: Sensorwicklung
- 3: Erregerwicklung
- 4: Koppelelement
- 10: Stromsensor/Sensorbaustein
- 11: Differenzierfunktion
- 12: Bandpassfunktion
- 20: Auswerteelektronik
- 21: Tiefpass
- 22: AD-Wandler
- 23: Normierglied
- 24: Zähler
- 30: Funktionsbaustein
- 40: Mikrocontroller

- S_{A}: Sensorsignal
- S'_{A}: Auswertesignal
- S_{D}: Digitalsignal
- S'_{D}: Pulssignal
- S"_{D}: verlängertes Pulssignal
- S₁: Stromsignal

## Patentansprüche

1. Verfahren zur Erfassung und Auswertung von Stromänderungen in Folge von Lichtbögen,
- bei dem ein nach der Zeit (t) differenziertes Sensorsignal (S_{A}) mit einer sensorabhängigen Frequenzbandbreite (f_{go1} - f_{gu}) erzeugt wird, deren obere Grenzfrequenz f_{go1} ≤ 40 MHz und deren untere Grenzfrequenz f_{gu} ≧ 100 kHz beträgt,
- bei dem aus dem Sensorsignal (S_{A}) ein Auswertesignal (S'_{A}) mit einer oberen Grenzfrequenz 1 MHz ≤ f_{go2} ≤ 10 MHz erzeugt wird,
- bei dem aus dem Auswertesignal (S'_{A}) ein normiertes Pulssignal (S_{D}, S'_{D}) erzeugt wird, und
- bei dem die Pulsdauer (Δt₁) des normierten Pulssignalsignals (S_{D}, S'_{D}) auf einen vorgegebenen Zeitwert (Δt₂) verlängert wird.

2. Verfahren nach Anspruch 1, bei dem die Signalhöhe (U) und die Pulsdauer (Δt₁) des unverlängerten Pulssignals (S'_{D}) auf einen vorgegebenen Zeitwert (Δt) normiert werden.

3. Verfahren nach Anspruch 1 oder 2, bei dem aufeinander folgende normierte Pulssignale (S'_{D}) innerhalb eines vorgegebenen Zeitfensters (Δt₂) gezählt werden.

4. Verfahren nach Anspruch 3, bei dem das Zeitfenster (Δt) auf ein Zeitintervall (Δt) im µs-Bereich eingestellt wird.

5. Verfahren nach Anspruch 3 oder 4, bei dem die Pulsdauer (Δt₁) eines einzelnen Signalpulses des Pulssignals (S'_{D}) verlängert wird, wenn innerhalb des Zeitfensters (Δt) zwei oder mehrere Signalpulse des Pulssignals (S'_{D}) gezählt werden.

6. Verfahren nach einem der Ansprüche 1 bis 5, bei dem die Pulsdauer (Δt₁) des Pulssignals (S'_{D}) auf Δt₂ » Δt₁ verlängert wird.

7. Vorrichtung zur Durchführung des Verfahrens nach einem der Ansprüche 1 bis 6,
- mit einem Stromsensor (10), der einen ferromagnetisches Koppelelement (4) und eine diesen umgebende Sensorwicklung (2) sowie eine den Strom (I_{P}) führende Erregerwicklung (3) aufweist,
- mit einer mit dem Stromsensor (10) verbundenen Auswerteelektronik (20), die dazu eingerichtet ist, das am Stromsensor (10), insbesondere an dessen Sensorwicklung (3) direkt, abgreifbare frequenzabhängige Sensorsignal (S_{A}) mittels eines Analog-Digital-Wandlers (22) in ein normiertes Signal (S_{D}, S'_{D}) umzuformen und die Pulsdauer (Δt₁) des Signals (S_{D}, S'_{D}) auf einen vorgegebenen Zeitwert (Δt₂) zu verlängern.

8. Vorrichtung nach Anspruch 7, bei der die Erregerwicklung (3) des Stromsensors (10) zur Sensorwicklung (2) beabstandet das Koppelement (4) umgibt und dabei über der Sensorwicklung (2) angeordnet ist.

9. Vorrichtung nach Anspruch 7 oder 8, bei der der Stromsensor (10) als Zeitdifferenzierglied (11) und als Bandpass (12) mit einer Bandfrequenz (f_{go1} - f_{gu}) zwischen 100 kHz und 40 MHz wirksam ist.

10. Vorrichtung nach einem der Ansprüche 7 bis 9, bei der die Auswerteelektronik (20) eingangsseitig einen dem Analog-Digital-Wander (22) vorgeschalteten Tiefpassfilter (21) mit einer Grenzfrequenz (f_{go2}) von 1 MHz bis 10 MHz aufweist.

11. Vorrichtung nach einem der Ansprüche 7 bis 10, bei der die Auswerteelektronik (20) ein dem Analog-Digital-Wander (22) nachgeschaltetes Normierglied (23) zur zeitlichen Normierung des Signals (S_{D}) aufweist.

12. Vorrichtung nach einem der Ansprüche 7 bis 11, bei der die Auswerteelektronik (20) einen Zählerbaustein (24) zur Erfassung einer Anzahl von Signalpulsen des Signals (S'_{D}) aufweist.

13. Vorrichtung nach einem der Ansprüche 7 bis 12, bei der ein der Auswerteelektronik (20) nachgeordneter Funktionsbaustein (30) zur Signalverarbeitung als Sample- and Hold-Schaltung zur Verlängerung der Pulsdauer (Δt₁) des Pulssignals (S'_{D}) auf den vorgegebenen Zeitwert (Δt₂) aufweist.

14. Vorrichtung nach einem der Ansprüche 7 bis 13, bei der der Analog-Digital-Wandler (22) als Komparator oder als 1-Bit-Wandler ausgeführt ist.

15. Vorrichtung nach einem der vorhergehenden Ansprüche, bei der der Stromsensor (10), die Auswerteelektronik (20), gegebenenfalls der Funktionsbaustein (30) zur Signalverarbeitung und/oder ein diesem nachgeordneter Mikrocontroller (40) in ein gemeinsames Gehäuse integriert sind.
